# EUROPÄISCHE PATENTSCHRIFT

(11) **EP 1 324 063 B1**
(45) Veröffentlichungstag und Bekanntmachung des Hinweises auf die Patenterteilung: **03.10.2012**
(21) Anmeldenummer: 02102818.8
(22) Anmeldetag: 19.12.2002
(51) Int. Cl.: G01R 33/09, G01R 33/06

(54) **Magnetoresistiver Sensor**
Magnetoresistive sensor
Capteur magnétorésistif

(30) Priorität: 20.12.2001 DE 10162752
(43) Veröffentlichungstag der Anmeldung: 02.07.2003
(73) Patentinhaber: NXP B.V., 5656 AG Eindhoven (NL)
(72) Erfinder: Döscher, Michael, 52088, Aachen (DE)
(74) Vertreter: Schouten, Marcus Maria

(56) Entgegenhaltungen:
- US-A- 4 097 802
- US-A1- 2002 180 433
- US-B1- 6 391 431

## Beschreibung

Die Erfindung betrifft einen magnetoresistiven Sensor mit wenigstens einem streifenförmigen, aus einem magnetoresistiven Werkstoff gebildeten Leiter, der zum Erfassen seines durch ein äußeres Magnetfeld beeinflußbaren elektrischen Widerstands und/oder zum Beaufschlagen mit einem elektrischen Strom eingerichtet ist.

Derartige Sensoren werden bevorzugt für Magnetfeld Strom-, Positions- und Bewegungsmessungen eingesetzt. Ein besonderes Anwendungsfeld sind dabei Winkel- und Drehzahlmessungen an zB. Nocken und Kurbelwellen für unterschiedliche Steuerungen in Verbrennungsmotoren.

Aus der WO 98/57188 A1 ist ein Sensor bekannt, der ein Substrat umfaßt, auf dem eine Mehrzahl von Widerstandselementen in einer Wheatstone-Brückenschaltung angeordnet ist, wobei wenigstens eines der Widerstandselemente einen magnetoresistiven Effekt zeigt. Die Widerstandselemente sind in Zweigen angeordnet, welche folgende Verbindungen herstellen: (a) einen Stromeingangsanschluß mit einem ersten Spannungsanschluß; (b) den ersten Spannungsanschuß mit einem Stromausgmigsmschluß; (c) den Stromausganschluß mit einem zweiten Sparmungsanschluß; (d) den zweiten Spannungsanschluß mit dem Stromeingangsanschluß. Dabei umfaßt der Sensor eine zweite Wheatstone-Brückenschaltung, die mit der beschriebenen ersten Wheatstone-Brückenschaltung elektrisch verbunden ist. Beide Wheatstone-Brückenschaltungen sind bis auf das Merkmal identisch, dass, wenn ein Ausgangssignal eines bestimmten magnetoresistiven Elements in einem bestimmten Zweig in einer der Wheatstone-Brückenschaltungen eine positive Polarität aufweist, das Ausgangssignal des dazu korrespondierenden magnetoresistiven Elements in demselben Zweig der anderen Wheatstone-Brückenschaltung eine negative Polarität zeigt. Insbesondere sind bei diesem Sensor die Zweige mit AMR-Elementen (anisotropen magndoresistiven Elementen) aufgebaut, wobei die Elemente beider Wheatstone-Brückenschaltungen raumsparend ineinander verschachtelt und parallel zueinander ausgerichtet auf dem Substrat untergebracht sind.

Aus der WO 95/28649 A1 ist ein aus schichtförmig angeordneten, magnetoresistiven Elementen aufgebauter Magnetfeldsensor bekannt. Die magnetoresistiven Elemente sind in Brückenschaltung auf einem Substrat angeordnet. Jedes magnetoresistive Element umfaßt eine mäanderförmige Leiterstruktur mit Leiterstreifen aus magnetoresistivem Material. Die magnetoresistiven Elemente umfassen zwei ferromagnetische Schichten, die eine einachsige Anisotropie in einer Ebene zeigen und durch eine nicht ferromagnetische Schicht voneinander getrennt sind. Während der Herstellung des Sensors werden die Magnetisierungsrichtungen dieser ferromagnetischen Schichten derart festgelegt, dass zwei Elemente in zwei benachbarten Zweigen der Brückenschaltung entgegengesetzte Empfindlichkeiten gegenüber äußeren Magnetfeldern zeigen. Außerdem ist in jedem der magnetoresistiven Elemente die Magnetisierung einer der ferromagnetischen Schichten im wesentlichen rechtwinklig zu der Magnetisierung der anderen ferromagnetischen Schicht eingestellt. Damit werden Hilfsfelder für die Messung kleiner magnetischer Feldstärken überflüssig; die Kennlinie des Sensors ist weitgehend frei von Hysterese und zeigt eine verbesserte Linearität.

Das Dokument US 4 097 802 zeigt bekannte Magnetoresistive Sensor gemäß der Oberbegriffe des Anspruch 1.

Es hat sich gezeigt, dass für manche Anwendungen die erreichten Kennlinieneigenschaften derartiger Sensoren, insbesondere noch vorhandene Hysterese und Abweichung von der Linearität, den Anforderungen nicht genügen.

Die Erfindung hat die Aufgabe, einen magnetoresistiven Sensor der eingangs genannten Art in der Weise auszubilden, dass eine weitere Verringerung der Hysterese und eine verbesserte Linearität erzielt werden.

Erfindungsgemäß wird einem magnetoresistiven Sensor mit einer Anordnung aus wenigstens zwei streifenförmigen, aus einem magnetoresistiven Werkstoff gebildeten Leitern, von denen wenigstens zwei sich im wesentlichen parallel zueinander erstrekken und von denen wenigstens ein als Randstreifen bezeichneter der Leiter eine Berandung der Anordnung der Leiter bildet, die gestellte Aufgabe dadurch gelöst, dass die Anordnung der Leiter von wenigstens einem der Schirmungsstreifen berandet ist, der wenigstens nahezu parallel zu und in vorgegebenem Abstand von dem wenigstens einen Randstreifen und von diesem elektrisch isoliert angeordnet ist.

Der Erfindung liegt die Erkenntnis zugrunde, dass Hysteresedgenschaften und Linearität der Kennlinie eines gattungsgemaß mit wenigstens einem streifenförmigen, aus einem magnetoresistiven Werkstoff gebildeten Leiter ausgestatteten Sensors wesentlich von der Gleichförmigkeit abhängen, mit der das angelegte Magnetfeld auf den Leiter einwirkt. Dies trifft insbesondere auf Sensoren zu, die eine Anordnung aus mehreren solchen Leitern aufweisen, d.h. ein Ensemble aus magnetoresistiven Streifen, die elektrisch parallel oder in Reihe geschaltet sind Im Betrieb überlagern sich dann die Einzelkennlinien aller derart zusammengeschalteter Streifen zu einer resultierenden Kennlinie des Sensors. Um optimale Sensoreigenschaften, insbesondere bezüglich der Parameter der Hysterese, der magnetischen "Härte" und der Empfindlichkeit, zu erreichen, zeigt es sich, dass alle diese zusammengeschalteten Streifen in identischer Weise auf das angelegte Magnetfeld reagieren sollten, abgesehen von einer ggf. erwünschten Inversion der Kennlinie einzelner Streifen bzw. Leiter durch eine dementsprechende Anordnung und Ausrichtung einer an sich bekannten sog Barberpol-Struktur.

Die aus den vorgenannten Druckschriften bekannten Sensoren beinhalten keinerlei Vorkehrungen zum Erreichen einer möglichst homogenen Einwirkung des Magnetfeldes auf den einzelnen Leiter entlang dessen Verlauf oder auf die verschiedenen Leiter einer Anzahl von Leitern Vielmehr zeigt sich bei genauer Untersuchung, dass einerseits nicht entlang der gesamten Erstreckung eines solchen Leiters eine homogene Einwirkung besteht und dass andererseits in einer Anzahl solcher Leiter eine von Leiter zu Leiter inhomogene Einwirkung auftreten kann. Dadurch reagieren nicht alle Teile eines Leiters und nicht alle Leiter untereinander identisch auf das angelegte Magnetfeld, was zu Hysterese, Nichtlinearitäten und erhöhtem Rauschen der Kennlinie führt. Diese Signalfehler begrenzen die Genauigkeit, mit der das Magnetfeld durch den Sensor gemessen werden kann.

Bei einer Anordnung eines eine Mehrzahl von streifenförmigen, aus einem magnetoresistiven Werkstoff gebildeten Leitern der beschriebenen Art umfassenden Sensors hat sich insbesondere gezeigt, dass ein als Randstreifen bezeichneter der Leiter, der eine Berandung der Anordnung der Leiter bildet, eine Kennlinie aufweist, die von der Kennlinie derjenigen der Leiter abweicht, die sich im. "Inneren" der Anordnung der Leiter erstrecken. Während sich für diese "inneren" Leiter eine als Abhängigkeit der sich ausbildenden magnetischen Induktion B von der Feldstärke H des angelegten Magnetfeldes dargestellte Hysteresekennlinie mit steilen Flanken und einem eindeutigen, reproduzierbaren Hystereseverhalten ergibt, zeigen Rand streifen flacher geneigte Hysteresekennlinien.

Als Ursache für dieses unterschiedliche Verhalten haben sich unterschiedliche Entmagnetisierungsfelder herausgestellt, die sich in der Umgebung der Leiter mit unterschiedlicher Entmagnetisierungpfeldstärke aufbauen und dadurch auf diese Leiter unterschiedlich ein wirken. Solche Entmagnetisierungsfelder entstehen durch äußere Störfelder, aber auch durch die Magnetfelder von in benachbarten Leitern fließenden elektrischen Strömen. Dabei wirken sich die in den streifenförmigen, aus magnetoresistivem Werkstoff gebildeten Leitern des Sensors fließenden Ströme grundsätzlich in gleicher Weise aus wie Ströme in nicht zum Sensor gehörenden, ihm jedoch benachbarten Leiteranordnungen, zB. Zuleitungen, Trimmstrukturen und dergleichen. Insbesondere bei einer Anordnung mit einer Mehrzahl von sich im wesentlichen parallel zueinander erstreckenden, strafenförmigen Leitern bauen sich entlang der "inneren" Leiter in der Regel im wesentlichen homogene Entmagnetisierungsfelder auf, wohingegen die auf die Randstreifen wirkenden Entmagnetisierungafelder davon in der Regel deutlich abweichen.

Auch bei einem nur einen einzigen streifenfönnigen, aus magnetoresistivem Werkstoff gebildeten Leiter aufweisenden Sensor kann dieser Leiter entlang seines Verlaufs diesen genannten unterschiedlichen, möglicherweise auch zeitlich schwankenden Entmagnetisierungsfeldern ausgesetzt sein, wodurch sich auch für eine derartige Konfiguration eine flacher geneigte Hysteresekennlinie und eine verschlechterte Linearität ergaben

Insbesondere hat sich gezeigt, dass die beschriebenen, inhomogenen Entmagnetisierungsfelder in den streifenförmigen, aus magnetoresistivem Werkstoff gebildeten Leitern zu Domänen bildung führen. Die dabei entstehenden Einzeldomänen unterschiedlicher Einwirkung der inhomogenen EnünagnetisLeningsfelder weisen im Betrieb unterschiedliches Schaltverhalten auf, wodurch sich die Veränderten Hysteresekennlinien derart beeinflußter Leiter ergeben. Solcherart örtlich inhomogene Entmagnetisierungsfelder unterstützen dabei einerseits die Bildung von Domänenaufspaltungen innerhalb eines einzigen Leiters und andererseits eine unterschiedliche magnetische "Härte" solcherart entstehender, einzelner Bereiche des Leiters

Die örtlich, dh im Bereich der räumlichen Erstreckung der zum Sensor gehörenden Leiter, inhomogenen Entmagnetisierungsfelder bewirken dabei neben einer Verringerung der Linearität der Kennlinie des mit wenigstens einem streifenförmigen, aus magnetoresistivem Werkstoff gebildeten Leiter ausgestatteten Sensors, d.h. der Verkleinerung des linearen Kennlinienbereichs dieses Sensors, insbesondere eines solchen, mit Banberpol-Strukturen ausgestatteten Sensors, auch erhöhtes Rauschen im Sensor, da alle Einzeldomänen ein magnetisch untershiedliches Schaltverhalten zeigen können, welches auch eine erhöhte Hysterese der Kennlinie des Sensors zur Folge hat.

Dieser Erkenntnis folgend gibt die Erfindung nun in einfacher Weise Maßnahmen an die Hand, durch die sichergestellt wird, dass die Entmagrietiserungsfelder auf alle zur Bildung des Sensors elektrisch verbundenen, aus magnetoresistivem Werkstoff gebildeten Leiter wenigstens nahezu identisch einwirken, so dass die elektrischen Ströme in den den Sensor bildenden Leitern nicht von im Bereich der räumlichen Erstreckung der zum Sensor gehören den Leiter inhomogenen Entmagnetisierungsfeldern ungünstig beeinflußt werden.

Die Homogenisierung der auf alle aus magnetoresistivem Werkstoff gebildeten, streifenförmigen Leiter des Sensors einwirkenden Magnetfelder, dh insbesondere der Entmagnetisierungsfelder, wird durch die erfindungsgemäße Anordnung der elektrisch getrennten Schirmungsstreifen erreicht.

Umfaßt ein solcher magnetoresistiver Sensor eine Anordnung aus wenigstens zwei streifenförmigen, aus einem magnetoresistiven Werkstoff gebildeten Leitern, von denen wenigstens zwei sich im wesentlichen parallel zueinander erstrecken und von denen wenigstens ein als Randstreifen bezeichneter der Leiter eine Berandung der Anordnung der Leiter bildet, ist die Anordnung der Leiter vorteilhaft von wenigstens einem der Schirmungsstreifen berandet, der wenigstens nahezu parallel zu und in vorgegebenem Abstand von dem wenigstens einen Randstreifen und von diesem elektrisch isoliert angeordnet ist. In einer bevorzugten Fortbildung der Erfindung ist dabei der Randstreifen durch einen der wenigstens zwei sich im wesentlichen parallel zueinander erstreckenden Leiter gebildet.

Auf diese Weise werden in dem beschriebenen Sensor auch den jeweils "randständigen" Leitern die Schirmungastreifen als benachbarte, streifenförmige Elemente zugeordnet. Durch diese Schirmungsstreifen wird erreicht, dass sich alle elektrisch zum Sensor verbundenen, streifenförmigen Leiter aus magnetoresistivem Material im "Inneren" einer Leiterkonfiguration befinden. Die magnetischen Eigenschaften dieser Leiter, insbesondere z.B. bezüglich Hysterese, linearität und Empfindlichkeit, werden durch diese Maßnahme zumindest nahezu identisch, abgesehen von fertigungsbedingten Abweichungen, die sich jedoch mit den gängigen, photolithographischen Herstellungverfahren für Leiter der beschriebenen Art in sehr engen Grenzen halten lassen Dagegen sich die Streifen, deren magnetische Eigenschaften von denen der elektrisch zum Sensor verbundenen, streifenförmigen Leiter in der beschriebenen Weise abweichen, mit diesem Sensor elektrisch nicht verbunden, können also auch keinen störenden Einfluß auf das Ausgangssignal des Sensors nehmen.

Durch die Schirmungsstreifen werden nicht allein die Entmagnetisierungsfelder für alle elektrisch zum Sensor verbundenen, streifenförmigen Leiter wenigstens nahezu identisch, sondern es werden auch störende äußere Magnetfelder, wie sie z.B. durch Zuleitungen, Trimmstrukturen und dergleichen hervorgerufen werden können, zumindest weitgehend von den elektrisch zum Sensor verbundenen, streifenförmigen Leitern abgeschirmt. Derartige Trimmstrukturen können ebenfalls wenigstens teilweise mit magnetoresistivem Werkstoff aufgebaut sein. Ihr Einfluß auf die elektrisch zum Sensor verbundenen, streifenförnzigen Leiter kann durch Formgebung und räumliche Lage bedingt unterschiedlich ausfallen. Die Trimmstrukturen erzeugen dabei magnetische Felder, die in benachbarten Leitern aus magnetoresistiven Werkstoffen zur beschriebenen Domänenaufspaltung führt, die wiederum die beschriebene erhöhte Hysterese bedingt.

Gemäß einer weiteren Fortbildung eines erfindungsgemäßen magnetoresistiven Sensors, in dem wenigstens eine ausgewählte Anzahl der von der Anordnung aus wenigstens zwei streifenförmigen, aus einem magnetoresistiven Werkstoff gebildeten, im wesentlichen parallel zueinander sich erstreckenden Leitern umfaßten Leiter zu wenigstens einer je wenigstens einen Zweig einer elektrischen Schaltung bildenden Gruppe von Leitern zusammengefaßt ist, ist wenigstens eine der Gruppen von Leitern von je wenigstens einem Schirmungsstreifen berandet. Mit dieser Gestaltung wird eine gemeinsame Schirmung wenigstens eines Teils der elektrisch zum Sensor verbundenen, streifenförmigen Leiter vorgenommen. Vorzugsweise wird damit eine gemeinsame Schirmung aller elektrisch zum Sensor verbundenen, streifenförmigen Leiter durch einen oder mehrere gemeinsame Schirmungstreifen vorgenommen.

Nach einer weiteren Fortbildung der Erfindung ist jeder Zweig der elektrischen Schaltung von je wenigstens einem Schirmungstreifen berandet ist. Vorzugsweise wird durch eine derartige Maßnahme eine getrennte Schirmung jedes einzelnen Zweiges der Schaltung vorgenommen. Damit können auch störende Einflüsse der Leiter unterschiedlicher Zweige aufeinander vermindert oder zumindest veitgehend unterbunden werden.

Bei einem magnetoresistiven Sensor der vorbeschriebenen Art können vorzugsweise wenigstens nahezu alle Leiter zumindest im wesentlichen parallel zueinander angeordnet sein. Eine derartige Gestaltung wird vorzugsweise für Drehzahlsensoren eingesetzt. Sie ermöglicht eine besonders einfache Ausführung der Schirmungsstreifen parallel zu den Leitern.

Bei einem magnetoresistiven Sensor der vombeschriebenen Art stimmen die Abstände des wenigstens einen Schirmungsstreifens zu dem wenigstens einen Randstreifen wenigstens nahezu mit den Abständen wenigstens zweier der im wesentlichen parallel zueinander sich erstreckenden Leiter untereinander überein. Dies ist sowohl in dem Fall anwendbar, in dem eine Schirmung für jede einzelne Gruppe bzw. jeden einzelnen Zweig der Schaltung getrennt vorgesehen ist, als auch, wenn eine gemeinsame Schirmung des gesamten Sensors vorgesehen ist. Ist eine gemeinsame Schirmung des gesamten Sensors vorgesehen, stimmen diese Abstände vorzugsweise auch mit den Abständen je zweier unterschiedlichen Zweigen zugeordneter und dadurch für denjenigen Zweig, dem sie zugeordnet sind, einen Randstreifen bildender Leiter überein. Ist zwischen diesen zwei benachbarten Randstreifen je wenigstens ein Schirmungsstreifen angeordnet, stimmen bevorzugt: auch die Abstände jedes dieser zwei benachbarten Randstreifen zu dem genannten Schirmungsstreifen untereinander und mit den Abständen der übrigen Leiter untereinander überein.

In einem magnetoresistiven Sensor, der einer anderen Ausgestaltung der Erfindung zugrunde liegt, sind wenigstens nahezu alle Leiter je wenigstens eines der Zweige der elektrischen Schaltung zumindest im wesentlichen parallel zueinander angeordnet. Dabei können die Leiter unterschiedlicher Zweige unterschiedliche Ausrichtungen aufweisen. Eine derartige Gestaltung wird insbesondere in Winkelsensoren verwendet, für die vorzugsweise eine drehsymmetrische Anordnung der Zweige gewählt ist. Die Leiter je eines Zweiges sind dabei untereinander im wesentlichen parallel, die Ausrichtung der Leiter wechselt jedoch von Zweig zu Zweig

In einem derartigen Sensor wird vorzugsweise eine getrennte Schirmung für jede einzelne Gruppe bzw. jeden einzelnen Zweig der Schaltung vorgesehen. Besonders bevorzugt stimmen in einer solchen Anordnung die Abstände des wenigstens einen Schirmungsstreifens zu dem wenigstens einen Randstreifen je wenigstens eines der Zweige der elektrischen Schaltung wenigstens nahezu mit den Abständen wenigstens zweier der im wesentlichen parallel zueinander sich erstreckenden Leiter des genannten der Zweige der elektrischen Schaltung untereinander überein. Mit dieser Abstandswahl wird eine besonders gute Homogenisierung erhalten.

Durch die Erfindung wird vorteilhaft eine Verringerung der Streuung der magnetfeldempfindlichen Eigenschaften der einzelnen Bestandteile eines Sensors, d.h. seiner einzelnen magnetoresistiven Leiter bzw Leiterabschnitte, der beschriebenen Art erreicht. Dies resultiert in einer erhöhten Reproduziergenauigkeit der resultierenden Ausgangssignale des in der erfindungsgemäßen Weise ausgebildeten Sensors, insbesondere bei der Messung von Magnetfeldern geringer magnetischer Feldstärke. Die erhöhte Reproduziergenauigkeit wirkt sich in einer Verringerung von Signalschwankungen der Ausgangssignale, einem größeren linearen Bereich der Kennlinie des Sensors, einer reduzierten Hysterese sowie in einer Reduktion des Rauschens aus

Die Erfindung wird im folgenden anhand einiger Ausführungsbeispele näher erläutert. Die Zeichnungen, in denen übereinstimmende Elemente mit denselben Bezugszeichen versehen sind, zeigen in
- Fig. 1: ein Beispiel für einen magnetoresistiven Sensor mit zueinander parallel angeordneten Leitetstreifen,
- Fig. 2: ein erstes Ausführungsbeispiel der Erfindung bei einem Sensor gemäß Fig 1,
- Fig. 3: ein Beispiel für einen Verlauf einer Hysteresekennlinie eines sich im "Inneren" der Anordnung der Leiter des Sensors nach Fig 1 erstreckenden Leiters,
- Fig. 4: ein Beispiel für einen Verlauf einer Hysteresekennlinie eines Randstreifens der Anordnung der Leiter des Sensors nach Fig 1,
- Fig. 5: eine schematische Darstellung der Kennlinie von Sensoren im Vergleich zwischen einer Anordnung mit (vgl. Fig 2) und ohne Sdirmungsstreifen (vgl. Fig 1),
- Fig. 6: eine schematische Darstellung einer Domänenbildung in magnetoresistiven Leiterstreifen eines Sensors der Fig 1 oder 2,
- Fig. 7: einen Winkelsensor als zweites Ausführungsbeispiel der Erfindung und
- Fig. 8: einen Sensor in einer Abwandlung der Konfiguration nach Fig 2 als drittes Ausführungsbeipiel der Erfindung

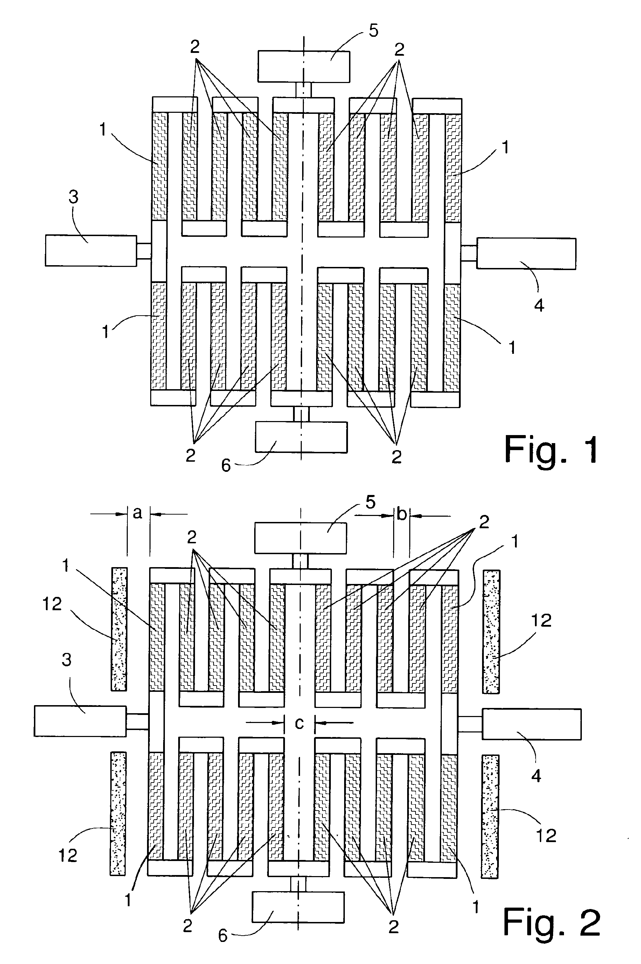

Fig 1 zeigt schematisch den Aufbau eines magnetoresistiven Sensors der bekannten Art in einer Draufsicht auf dessen Leiterstruktur. Der Sensor umfaßt eine Anordnung aus einer Anzahl streifenförmiger, aus einem magnetoresistiven Werkstoff gebildeter Leiter 1, 2, die sich in zwei Reihen im wesentlichen parallel zueinander erstrecken und von denen die mit dem Bezugszeichen 1 versehenen, randständigen Leiter eine Berandung der Anordnung der Leiter bilden und daher als Randstreifen bezeichnet werden, wohingegen die übrigen, mit dem Bezugszeichen 2 versehenen Leiter allseits von wenigstens einem anderen der Leiter 1 oder 2 berandet sind, sich also im "inneren" der Anordnung der Leiter erstrecken und daher im Folgenden als innere Leiter bezeichnet werden Je vier benachbarte der inneren Leiter 2 und ein diesen benachbarter Randstreifen 1 in jeder der Reihen der Leiter sind in dem dargestellten Beispiel zueinander elektrisch in Reihe geschaltet und stellen einen Zweig einer als Wheatstone-Brücke ausgebildeten elektrischen Schaltung dar. Diese Wheatstone-Brücke ist mit zwei Anschlüssen 3, 4 versehen, über die im Betrieb eine Speisespannung angelegt wird, sowie mit zwei weiteren Anschlüssen 5, 6, über denen eine ein Ausgangssignal des Sensors bildende Ausgangsspannung abgegriffen werden kann.

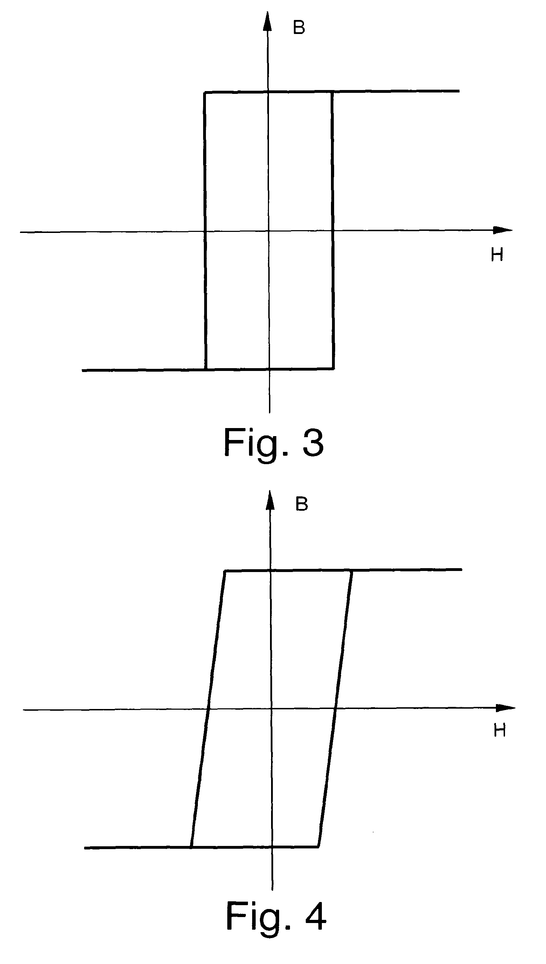

Fig. 3 zeigt schematisch ein Beispiel für eine als Abhängigkeit der sich ausbildenden magnetischen Induktion B von der Feldstärke H des angelegten Magnetfeldes dargestellte Hysteresekennlinie, wie sie sich für einen der inneren Leiter 2 des Sensors nach Fig 1 ergibt. Diese Hysteresekennlinie des inneren Leiters 2 des Sensors weist einen sehr steilen Verlauf mit einen eindeutigen, reproduzierbaren Hystereseverhalten auf.

Fig 4 zeigt im Vergleich dazu eine schematische Darstellung eines Beispiels für eine derartige Hysteresekennlinie der sich ausbildenden magnetischen Induktion B in Abhängigkeit von der Feldstärke H des angelegten Magnetfeldes, wie sie sich für einen der Randstreifen 1 des Sensors nach Fig 1 ergibt. Diese Hysteresekennlinie des Randstreifens 1 des Sensors zeigt einen flacher geneigten Verlauf. Das dadurch beschriebene Hystereseverhalten ist weit weniger eindeutig und reproduzierbar.

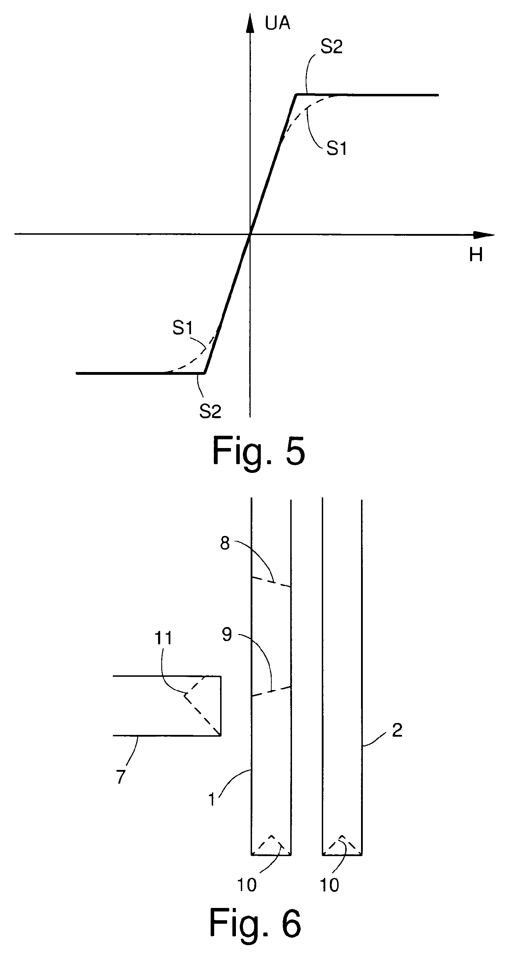

Die als Ursache für diesen flacher geneigten Verlauf der Hysteresekennlinie des Randstreifens 1 des Sensors nach Fig 1 erkannte Domänenbildung mit der daraus resultierenden Überlagerung des Schaltverhaltens verschiedener Einzeldomänen ist anhand der Fig 6 schematisch dargestellt. Darin ist mit dem Bezugszeichen 7 eine Trimmstruktur als Beispiel einer äußeren Leiteranordnung bezeichnet, welche mit ihrem Entmagrietisierungsfeld Einfluß auf die Domänenbildung im Randstreifen 1 nimmt. In diesem Randstreifen 1 bilden sich außer einer Abschlußdomänenwand 10 weitere Domänenwände 8, 9. Die durch sie getrennten und als Domänen bezeichneten Abschnitte des Randstreifens 1 weisen unterschiedliches Verhalten, dh unterschiedliche Abhängigkeiten des elektrischen Widerstand von der Feldstärke des angelegten Magnetfelds, auf. Dadurch zeigt der Randstreifen 1 eine von derjenigen der inneren Leiter 2 abweichende Hysteresekennlinie

Im übrigen entstehen durch eine wechselseitige Beeinflussung des Randstreifens 1 und der Trimmstruktur 7 auch in der letzteren Domänenwände, hier schematisch mit dem Bezugszeichen 11 bezeichnet, die jedoch für die Erfindung nicht von wesentlicher Bedeutung sind Fig. 5 zeigt in schematischer Darstellung als gestrichelte Linie S1 die Kennlinie eines Sensors gemäß Fig. 1. Aufgetragen ist die Ausgangspannung UA des Sensors zwischen den Anschlüssen 5 und 6 über der magnetischen Feldstärke H des angelegten Magnetfeldes, Im Bereich des Übergangs dieses Kennlinienverlaufs S1 in die hier als Sättigung bezeichneten, waagerecht verlaufenden Kennlinienabschnitte über der magnetischen Feldstärke H des angelegten Magnetfeldes konstanter Ausgangsspannung UA des Sensors zeigen sich deutliche Ausrundungen der Kennlinie, die den Mittelabschnitt der Kennlinie, in dem ein wenigstens weitgehend linearer Zusammenhang zwischen der Ausgangsspannung UA des Sensors und der magnetischen Feldstärke H des angelegten Magnetfeldes gegeben ist, deutlich einengt.

In Fig 2 ist ein erstes Ausführungsbdspid der Erfindung schematisch dargestellt, welches sich an der Anordnung des Sensors nach Fig 1 orientiert. Gegenüber dieser ist der Sensor nach Fig 2 mit zusätzlichen Schirmungsstreifen 12 versehen, von denen je einer benachbart zu je einem der Randstreifen 1 und parallel dazu sich erstreckend, jedoch elektrisch von diesen getrennt angeordnet ist. Durch diese Schirmungsstreifen 12 wird erreicht, dass sich eine Domänenbildung wie in Fig 6 für einen der Randstreifen 1 gezeigt nun nicht mehr in diesem Randstreifen 1, sondern vielmehr im parallel dazu verlaufenden, benachbarten Schirmungsstreifen 12 vollzieht. Der Randstreifen 1 verhält sich jetzt dagegen magnetisch wie einer der inneren Leiter 2, weist also keine Domänenbildung mehr auf, abgesehen von der für alle Leiter übereinstimmenden Bildung der Abschlußdomänen 10. Alle elektrisch miteinander zum Sensor verbundenen Leiter 1, 2 zeigen nun dasselbe magnetische Verhalten.

Vorzugsweise stimmen in der Anordnung dieses Sensors nach Fig. 2 die dort der Deutlichkeit halber unterschiedlich gezeichneten Abstände a der Schirmungsstreifen 12 zu den ihnen benachbarten Randstreifen 1 mit den Abständen b je zweier zueinander benachbarter der inneren Leiter 2 untereinander bzw. der Randstreifen 1 zu den ihnen benachbarten inneren Leitern 2 überein. Weiterhin stimmen bevorzugt auch die Abstände c der einander benachbarten inneren Leiter 2 verschiedener Zweige der Wheatstone-Brücke mit den Abständen a und b überein.

In der Sensoranordnung der Fig 2 zeigen alle elektrisch zum Sensor verbundenen Leiter 1, 2 eine Hysteresekennlinie gemäß Fig 3 mit einem steilen Verlauf. In Fig 5 ist außerdem die Kennlinie S2 der Ausgangsspannung UA des Sensors nach Fig 2 über der magnetischen Feldstärke H des angelegten Magnetfeldes dargestellt, so dass Fig 5 einen Vergleich der Kennlinie S1 des herkömmlichen Sensors mit derjenigen des erfindungsgemäßen Sensors zeigt. Die Kennlinie S2 des erfindungsgemäßen Sensors ist in Fig 5 in Vollinie wiedergegeben und weist in den Übergangen zwischen dem linearen Bereich und der Sättigung zumindest weitgehend scharfe Knicke auf, dh der lineare Bereich dieser Kennlinie S2 ist gegenüber dem der Kennlinie S1 des herkömmlichen Sensors wesentlich erweitert.

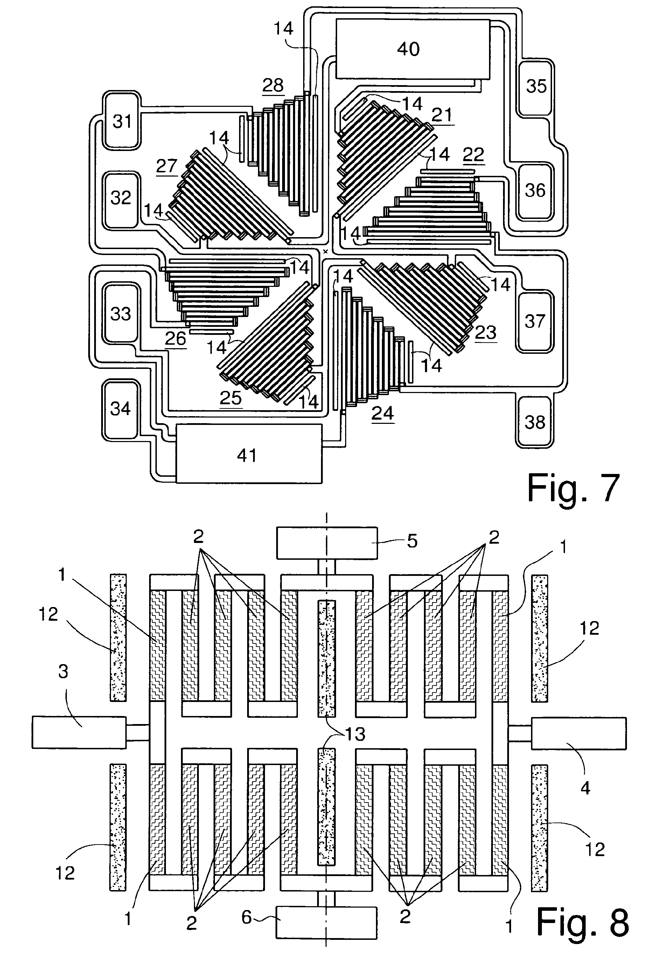

In Fig 7 ist als zweites Ausführungsbeispiel der Erfindung ein Winkelsensor dargestellt, der in seinem grundsätzlichen Aufbau an sich bekannt ist und daher nicht im einzelnen naher erläutert werden soll. Bei diesem Winkelsensor sind die Leiter aus magnetoresistivem Werkstoff auf insgesamt acht Zweige 21 bis 28 verteilt, die in zwei räumlich verschachtelt angeordneten Wheatstone-Brücken elektrisch miteinander verbunden sind Die Wheatstone-Brücken sind über acht Anschlüsse 31 bis 38 mit Speisespannungen beaufschlagbar bzw. sind über diese Anschlüsse Ausgangspannungen der Wheatstone-Brücken abgreifbar. Blockschematisch ist außerdem für jede der Wheatstone-Brücken eine dem elektrischen Abgleich der mit ihr verbundenen Wheatstone-Brücke dienende Trimmstruktur 40 bzw. 41 vorgesehen, die in die Verbindungen des Anschlusses 36 bzw. 34 mit den Zweigen 21 und 27 bzw. 24 und 26 eingefügt ist. Jeder der acht Zweige 21 bis 28 umfaßt eine Anzahl zueinander parallel sich erstreckender, magnetoresistiver Leiter, die elektrisch zueinander in Reihe geschaltet sind, wobei die räumliche Ausrichtung dieser Leiter von Zweig zu Zweig dergestalt um einen vorbestimmten Winkel - hier 45° - versetzt ist, dass alle Zweige 21 bis 28 insgesamt eine drehsymmetrische Anordnung bilden.

In jedem der acht Zweige 21 bis 28 sind die miteinander elektrisch zum Sensor verbundenen Leiter von Schirmungsstreifen 14 berandet, die beidseitig jedes der acht Zweige 21 bis 28 parallel zu deren äußeren Leitern, d.h. deren Randstreifen, angeordnet sind In dem derart ausgebildeten Sensor ist somit jeder der einzelnen Zweige 21 bis 28 mit einer gesonderten Schirmung versehen. Weitere, nicht dargestellte Schirmungen der Zweige 21 bis 28 können in dieser Anordnung angebracht werden, beispielsweise entlang der Enden der einzelnen Leiter jedes der Zweige und damit weitgehend quer zur Längsrichtung dieser Leiter. Derartige, zusätzliche Schirmungen können bevorzugt mit Schirmungsstreifen ausgeführt sein, deren Gestalt derjenigen der Schirmungsstreifen 14 entspricht und die insbesondere zu diesen ebenfalls elektrisch getrennt angeordnet sind

In einer an das zweite Ausführungsbeispiel nach Fig 7 angelehnten Abwandlung der Konfiguration der Fig 2 zeigt Fig 8 ein drittes Ausfülmmgbeispiel der Erfindung bei dem in der ansonsten identisch übernommenen Konfiguration der Fig 2 zusätzliche Schirmungsstreifen 13 vorgesehen sind, die sich parallel zu den einander benachbarten inneren Leitern 2 unterschiedlicher Zweige der Wheatstone-Brücke zwischen diesen erstrecken und eine Schirmung der Zweige gegeneinander bewirken.

### BEZUGSZEICHENLISTE

- 1: Randstreifen = aus einem magnetoresistiven Werkstoff gebildeter, randständiger Leiter des Sensors
- 2: Innerer Leiter = aus einem magnetoresistiven Werkstoff gebildeter Leiter im Inneren des Sensors
- 3: Anschluß der Wheatstone-Brücke zum Anlegen einer Speisespannung
- 4: Anschluß der Wheatstone-Brucke zum Anlegen einer Speisespannung
- 5: Anschluß der Wheatstone-Brücke zum Abgreifen der ein Ausgangssignal des Sensors bildenden Ausgangsspannung UA
- 6: Anschluß der Wheatstone-Brücke zum Abgreifen der ein Ausgangssignal des Sensors bildenden Ausgangsspannung UA
- 7: Trimmstruktur als Beispiel einer äußeren Leiteranordnung
- 8: Weitere Domänenwand
- 9: Weitere Domänenwand
- 10: Abschlußdornanenwand
- 11: Domänenwand in der Trimmstruktur 7
- 12: Schirmungsstreifen
- 13: Zusätzliche Schirmungsstreifen parallel zu und zwischen den einander benachbarten inneren Leitern 2 unterschiedlicher Zweige der Wheatstone-Brücke
- 14: Schirmungstreifen zu jedem der acht Zweige 21 bis 28 des Sensors nach Fig 7
- 21: Zweig des Winkelsensors nach Fig. 7 mit Leitern aus magnetoresistivem Werkstoff als Teil einer von zwei räumlich verschachtelt angeordneten Wheatstone-Brücken
- 22: Zweig des Winkelsensors nach Fig. 7 mit Leitern aus magnetoresistivem Werkstoff als Teil einer von zwei räumlich verschachtelt angeordneten Wheatstone-Brücken
- 23: Zweig des Winkelsensors nach Fig 7 mit Leitern aus magnetoresistivem Werkstoff als Teil einer von zwei räumlich verschachtelt angeordneten Wheatstone-Brücken
- 24: Zweig des Winkelsensors nach Fig 7 mit Leitern aus magnetoresistivem Werkstoff als Teil einer von zwei räumlich verschachtelt angeordneten Wheatstone-Brücken
- 25: Zweig des Winkelsensors nach Fig. 7 mit Leitern aus magnetoresistivem Werkstoff als Teil einer von zwei räumlich verschachtelt angeordneten Wheatstone-Brücken
- 26: Zweig des Winkelsensors nach Fig. 7 mit Leitern aus magnetoiesistivem Werkstoff als Teil einer von zwei räumlich verschachtelt angeordneten Wheatstone-Brücken
- 27: Zweig des Winkelsensors nach Fig 7 mit Leitern aus magnetoresistivem Werkstoff als Teil einer von zwei räumlich verschachtelt angeordneten Wheatstone-Brücken
- 28: Zweig des Winkelsensors nach Fig 7 mit Leitern aus magnetoresistivem Werkstoff als Teil einer von zwei räumlich verschachtelt angeordneten Wheatstone-Brücken
- 31: Anschluß einer der Wheatstone-Brücken zum Beaufschlagen mit einer Speisespannung bzw. zum Abgreifen einer Ausgangsspannung der Wheatstone-Brücke
- 32: Anschluß einer der Wheatstone-Brücken zum Beaufschlagen mit einer Speisespannung bzw. zum Abgreifen einer Ausgangsspannung der Wheatstone-Brücke
- 33: Anschluß einer der Wheatstone-Brücken zum Beaufschlagen mit einer Speisespannung bzw zum Abgreifen einer Ausgangsspannung der Wheatstone-Brücke
- 34: Anschluß einer der Wheatstone-Brücken zum Beaufschlagen mit einer Speisespannung bzw. zum Abgreifen einer Ausgangsspannung der Wheatstone-Brücke
- 35: Anschluß einer der Wheatstone-Brücken zum Beaufschlagen mit einer Speisespannung bzw zum Abgreifen einer Ausgangspannung der Wheatstone-Brücke
- 36: Anschluß einer der Wheatstone-Brücken zum Beaufschlagen mit einer Speisespannung bzw. zum Abgreifen einer Ausgangsspannung der Wheatstone-Brücke
- 37: Anschluß einer der Wheatstone-Brücken zum Beaufschlagen mit einer Speisespannung bzw. zum Abgreifen einer Ausgangsspannung der Wheatstone-Brücke
- 38: Anschluß einer der Wheatstone-Brücken zum Beaufschlagen mit einer Speisespannung bzw. zum Abgreifen einer Ausgangsspannung der Wheatstone-Brücke
- 40: Trimmstruktur in der Verbindung des Anschlusses 36 mit den Zweigen 21 und 27
- 41: Trimmstruktur in der Verbindung des Anschlusses 34 mit den Zweigen 24 und 26
- a: Abstände der Schirmungsstreifen 12 zu den ihnen benachbarten Randstreifen 1
- b: Abstände je zweier zueinander benachbarter innerer Leiter 2 untereinander bzw. der Randstreifen 1 zu den ihnen benachbarten inneren Leitern 2
- c: Abstände der einander benachbarten inneren Leiter 2 verschiedener Zweige der Wheatstone-Brücke
- B: Magnetische Induktion
- H: Magnetische Feldstärke des angelegten Magnetfeldes
- S1: Kennlinie der Ausgangsspannung UA über der magnetischen Feldstärke H des angelegten Magnetfeldes für einen Sensor gemäß Fig 1
- S2: Kennlinie der Ausgangsspannung UA über der magnetischen Feldstärke H des angelegten Magnetfeldes für einen Sensor gemäß Fig 2
- UA: Ausgangsspannung des Sensors zwischen den Anschlüssen 5 und 6

## Patentansprüche

1. Magnetoresistiver Sensor mit einer Anordnung aus wenigstens zwei streifenförmigen (2), aus einem magnetoresistiven Werkstoff gebildeten Leitern, wobei die leite zum Erfassen ihres durch ein äußeres Magnetfeld beeinflussbaren elektrischen Widerstand und zum Beaufschlagen mit einem elektrischen Strom eingerichtet sind, von denen wenigstens zwei sich im wesentlichen parallel zueinander erstrecken und von denen wenigstens ein als Randstreifen (1) bezeichneter der Leiter eine Berandung der Anordnung der Leiter bildet,
**dadurch gekennzeichnet,**
**dass** die Anordnung der Leiter von wenigstens einem Schirmungsstreifen berandet ist, der wenigstens nahezu parallel zu und in vorgegebenem Abstand von dem wenigstens einen Randstreifen (1) und von diesem elektrisch isoliert angeordnet ist.

2. Magnetoresistiver Sensor nach Anspruch 1
**dadurch gekennzeichnet,**
**dass** der Randstreiren (1) durch einen der wenigstens zwei sich im wesentlichen parallel zueinander erstreckenden Leiter gebildet ist.

3. Magnetoresistiver Sensor nach Anspruch 2, in dem. wenigstens eine ausgewählte Anzahl der von der Anordnung aus wenigstens zwei streifenförmigen, aus einem magnetoresistiven Werkstoff gebildeten, im wesentlichen parallel zueinander sich erstreckenden Leitern umfassten Leiter zu wenigstens einer je wenigstens einen Zweig einer elektrischen Schaltung bildenden Gruppe von Leitern zusammengefaßt ist,
**dadurch gekennzeichnet,**
**dass** wenigstens eine der Gruppen von Leitern von je wenigstens einem Schirmungsstreifen berandet ist.

4. Magnetoresistiver Sensor nach Anspruch 3,
**dadurch gekennzeichnet,**
**dass** jeder Zweig der elektrischen Schaltung von je wenigstens einem Schirmungsstreifen berandet ist.

5. Magnetoresistiver Sensor nach Anspruch 1, 2, 3 oder 4,
**dadurch gekennzeichnet,**
**dass** wenigstens nahezu alle Leiter zumindest im wesentlichen parallel zueinander angeordnet sind.

6. Magnetoresistiver Sensor nach Anspruch 1, 2, 3, 4 oder 5,
**dadurch gekennzeichnet,**
**dass** die Abstände des wenigstens einen Schirmungsstreifens zu dem wenigstens einen Randstreifen wenigstens nahezu mit den Abständen wenigstens zweier der im wesentlichen parallel zueinander sich erstreckenden Leiter untereinander übereinstimmen.

7. Magnetoresistiver Sensor nach Anspruch 1, 2 oder 3,
**dadurch gekennzeichnet,**
**dass** wenigstens nahezu alle Leiter je wenigstens eines der Zweige der elektrischen Schaltung zumindest im wesentlichen parallel zueinander angeordnet sind.

8. Magnetoresistiver Sensor nach Anspruch 7,
**dadurch gekennzeichnet,**
**dass** die Abstände des wenigstens einen Schirmungsstreifens zu dem wenigstens einen Randstreifen je wenigstens eines der Zweige der elektrischen Schaltung wenigstens nahezu mit den Abständen wenigstens zweier der im wesentlichen parallel zueinander sich erstreckenden Leiter des genannten der Zweige der elektrischen Schaltung untereinander übereinstimmen.

## Claims

1. A magneto resistive sensor having an arrangement of at least two strip-shaped (2) conductors which are formed from a magneto resistive material, wherein the conductors are adapted for determining their electric resistance which is influenceable by an external magnetic field and for loading with an electric current, of which at least two extend substantially parallel to each other and of which at least one, referred to as edge strip (1), forms an edge of the arrangement of the conductors,
**characterized in that**
the arrangement of the conductors is delimited by at least one shield strip which is arranged at least nearly parallel to and in a predetermined distance from the at least one edge strip (1) and electrically insulated from this edge strip (1).

2. The magneto resistive sensor according to claim 1, **characterized in that** the edge strip (1) is formed by one of the at least two conductors extending substantially parallel to each other.

3. The magneto resistive sensor according to claim 2, in which at least a selected number of the conductors included by the arrangement of at least two strip-shaped conductors consisting of a magneto resistive material and extending substantially parallel to each other are combined to at least one group of conductors, each group forming at least one branch of an electric circuit,
**characterized in that**
at least one of the groups of conductors is delimited by at least one shield strip.

4. The magneto resistive sensor according to claim 3, **characterized in that** each branch of the electric circuit is delimited by at least one shield strip.

5. The magneto resistive sensor according to claim 1, 2, 3, or 4, **characterized in that** at least nearly all conductors are arranged substantially parallel to each other.

6. The magneto resistive sensor according to claim 1, 2, 3, 4, or 5, **characterized in that** the distances of the at least one shield strip to the at least one edge strip are at least nearly consistent among each other with the distances of at least two of the conductors extending substantially parallel to each other.

7. The magneto resistive sensor according to claim 1, 2, or 3, **characterized in that** at least nearly all conductors of at least one of the branches of the electric circuit are arranged at least substantially parallel to each other.

8. The magneto resistive sensor according to claim 7, **characterized in that** the distances of the at least one shield strip to the at least one edge strip of at least one of the branches of the electric circuit are at least nearly consistent among each other with the distances of at least two of conductors of the electric circuit, which extend substantially parallel to each other.

## Revendications

1. Capteur magnétorésistif comportant un ensemble composé d'au moins deux conducteurs en forme de bande (2), formés à partir d'un matériau magnétorésistif, dans lequel les conducteurs sont installés afin de détecter leur résistance électrique pouvant être influencée par un champ magnétique extérieur et afin d'appliquer un courant électrique, parmi lesquels au moins deux conducteurs s'étendent essentiellement de manière parallèle l'un par rapport à l'autre et parmi lesquels au moins un conducteur désigné comme bande latérale (1) constitue le bord de l'ensemble des conducteurs,
**caractérisé en ce**
**que** l'ensemble des conducteurs est bordé par au moins une bande de blindage, laquelle est disposée au moins quasiment de manière parallèle par rapport à la bande de bord (1) au moins au nombre de une et à une distance prédéfinie de cette dernière et est disposée de manière isolée électriquement par rapport à ladite bande de bord.

2. Capteur magnétorésistif selon la revendication 1,
**caractérisé en ce**
**que** la bande de bord (1) est formée par un des conducteurs au moins au nombre de deux s'étendant essentiellement de manière parallèle les uns par rapport aux autres.

3. Capteur magnétorésistif selon la revendication 2, dans lequel au moins un nombre sélectionné de conducteurs compris dans l'ensemble constitué d'au moins deux conducteurs en forme de bande, formés à partir d'un matériau magnétorésistif, s'étendant essentiellement de manière parallèle les uns par rapport aux autres est regroupé pour former au moins un groupe de conducteurs formant respectivement au moins une branche d'un circuit électrique,
**caractérisé en ce**
**qu'**au moins un des groupes de conducteurs est bordé par respectivement au moins une bande de blindage.

4. Capteur magnétorésistif selon la revendication 3,
**caractérisé en ce**
**que** chaque branche du circuit électrique est bordée par respectivement au moins une bande de blindage.

5. Capteur magnétorésistif selon la revendication 1, 2, 3 ou 4,
**caractérisé en ce**
**qu'**au moins presque tous les conducteurs sont disposés au moins essentiellement de manière parallèle les uns par rapport aux autres.

6. Capteur magnétorésistif selon la revendication 1, 2, 3, 4 ou 5,
**caractérisé en ce**
**que** les distances entre la bande de blindage au moins au nombre de une et la bande de bord au moins au nombre de une coïncident au moins presque avec les distances entre au moins deux des conducteurs s'étendant essentiellement de manière parallèle l'un par rapport à l'autre.

7. Capteur magnétorésistif selon la revendication 1, 2 ou 3,
**caractérisé en ce**
**qu'**au moins presque tous les conducteurs respectivement d'au moins une des branches du circuit électrique sont disposés au moins essentiellement de manière parallèle les uns par rapport aux autres.

8. Capteur magnétorésistif selon la revendication 7,
**caractérisé en ce**
**que** les distances entre la bande de blindage au moins au nombre de une et la bande de bord au moins au nombre de une respectivement d'une au moins des branches du circuit électrique coïncident au moins presque avec les distances entre au moins deux conducteurs de ladite branche du circuit électrique s'étendant essentiellement de manière parallèle l'un par rapport à l'autre.
